# FASCICULE DE BREVET EUROPEEN

(11) **EP 2 744 760 B1**
(45) Date de publication et mention de la délivrance du brevet: **14.11.2018**
(21) Numéro de dépôt: 12758545.3
(22) Date de dépôt: 06.08.2012
(51) Int. Cl.: C03C 17/00, C03C 17/36, C23C 16/513, G02B 1/11, H01L 31/0216

(54) **Vitrage antireflet muni d'un revetement poreux et procédé de fabrication**
Antireflexverglasungseinheit mit einer porösen Beschichtung und Verfahren zur Herstellung
Antireflection glazing unit equipped with a porous coating and method of making

(30) Priorité: 18.08.2011 FR 1157400
(43) Date de publication de la demande: 25.06.2014
(73) Titulaire: Saint-Gobain Glass France, 92400 Courbevoie (FR)
(72) Inventeur: GIRON, Jean-Christophe, Edina, Minnesota 55436 (US); PETERSEN, Christian Bernhard, 52064 Aachen (DE); MELCHER, Martin, 52134 Herzogenrath (DE); NADAUD, Nicolas, 75013 Paris (FR)
(74) Mandataire: Saint-Gobain Recherche
(86) Numéro de dépôt international: PCT/FR2012/051850
(87) Numéro de publication internationale: WO 2013/024226

(56) Documents cités:
- EP-A1- 1 679 291
- FR-A1- 2 871 243

## Description

L'invention concerne un revêtement antireflet appliqué sur un substrat de verre et du vitrage à forte transmission énergétique ainsi obtenu, notamment dans la gamme de longueur d'onde 300-2500 nm.

Un tel vitrage trouve notamment son application dans les dispositifs utilisés pour le recouvrement de l'énergie lumineuse solaire, notamment dans le domaine des cellules photovoltaïques ou des collecteurs solaires.

Il est bien connu qu'une partie de la lumière traversant un substrat notamment verrier, est réfléchie à la surface de celui-ci, le taux de réflexion étant proportionnelle à l'angle d'incidence de la lumière. Une telle réflexion diminue de façon sensible le rendement des systèmes photovoltaïques ou des collecteurs solaires protégés par le substrat. Dans le domaine du bâtiment ou de l'automobile, il est également recherché parfois une diminution de la réflexion lumineuse, pour des raisons de sécurité et/ou esthétiques ou encore pour en améliorer le coefficient de transmission énergétique et/ou le facteur solaire FS.

Le principe de dépôt d'un revêtement antireflet sur un substrat transparent du type verrier est bien connu de l'art : il s'agit de disposer sur le substrat, d'indice de réfraction d'environ n = 1,5, une couche ou un empilement de couches interférentielles permettant de diminuer le pourcentage de lumière réfléchie à la surface du substrat.

Par l'ajustement du nombre, de la nature chimique (et donc de leur indice optique) et des épaisseurs des différentes couches successives de l'empilement, il est possible de ramener la réflexion à des valeurs extrêmement faibles, que ce soit dans le domaine du visible (350 à 800 nm) ou dans le domaine de l'infrarouge proche (800 à 2500 nm).

Par exemple, il a déjà été décrit par la société déposante, notamment dans la demande EP 1206715 A1, des empilements antireflets comprenant une succession de couches à bas et haut indices, permettant l'obtention de vitrages à propriétés antireflets. Les différentes couches minces interférentielles constituant les empilements sont classiquement déposées par les techniques de dépôt sous vide du type pulvérisation cathodique.

Selon une autre technique, il a été également été proposé, notamment dans le brevet EP 1 181 256 B1, des revêtements antireflets constitués par une unique couche d'un matériau essentiellement constitué d'oxyde de silicium poreux. Selon cet art antérieur, la mise en oeuvre d'un tel matériau poreux, dont l'épaisseur de la couche est ajustée en fonction de la longueur d'onde du rayonnement incident, permet de diminuer l'indice de réfraction jusqu'à des valeurs voisines de 1,22, et par suite d'obtenir une réflexion presque très réduite à la surface d'un substrat de verre d'indice 1,5, cette couche gardant l'essentiel de sa porosité lors d'un frittage à au moins 630°C. Le procédé de synthèse d'une telle couche comprend l'étape essentielle de la condensation hydrolytique par voie sol-gel d'un composé du silicium du type RSiX₄.

La demande de brevet EP 1 679 291 décrit, toujours pour l'obtention d'une couche en oxyde de silicium poreux d'indice de réfraction inférieur à celui du verre utilisé comme substrat, des procédés comprenant selon une première étape le dépôt chimique en phase vapeur (ou CVD selon l'appellation anglaise Chemical Vapor Deposition) ou le dépôt physique en phase vapeur (ou PVD de l'anglais Physical Vapor Deposition), d'une couche primaire d'un matériau contenant de l'oxygène, du silicium, du carbone et de l'hydrogène. Selon une seconde étape, la couche primaire est soumise à un traitement thermique (chauffage) permettant l'obtention, par élimination d'au moins une partie du carbone et de l'hydrogène présent dans la couche primaire, d'une couche poreuse, présentant une porosité de l'ordre du nanomètre.

La demande EP 1 679 291 décrit notamment comme mode possible un procédé PVD comprenant la pulvérisation d'une cible en silicium métallique ou en silice, dans une atmosphère réactive comprenant un mélange d'alcènes ou d'un mélange alcène/oxygène, dans un gaz plasma d'argon ou d'argon/oxygène. Une source supplémentaire de silicium peut être introduite dans le gaz plasma, afin d'augmenter la vitesse de dépôt de la couche sur le substrat.

Une telle réalisation pose cependant tout d'abord des problèmes en ce qui concerne la couche finalement obtenue : si on choisit d'utiliser une cible en silicium pur, les essais menés ont montrés qu'il n'était pas possible d'obtenir des couches à bas indice, par référence à l'indice de réfraction du matériau non poreux. Par matériau poreux à « bas » indice, on entend au sens de la présente invention un matériau dont la porosité entraîne l'abaissement dudit indice d'au moins 5% ou même 10% par rapport à celui connu du matériau non poreux. On entend par indice ou indice de réfraction au sens de la présente invention l'indice de réfraction mesuré à une même longueur d'onde de 550 nm.

Notamment, quelque soit la cible utilisée (oxyde de silicium ou silicium métallique), une partie nécessairement importante du matériau déposé est du dioxyde de silicium dense dont l'indice de réfraction est élevé (1,47). De ce fait il n'apparaît pas possible selon de telles techniques de fabrication d'obtenir au final une couche poreuse dans sa totalité, et par suite les plus bas indices théoriquement possibles de l'indice de réfraction.

En outre, l'utilisation d'une cible en oxyde de silicium est problématique car le matériau n'étant pas conducteur, il constitue une cathode de très mauvaise qualité, entraînant la présence d'arcs électriques dans l'installation. En outre, l'utilisation de telles cibles selon les techniques dites de pulvérisation (ou sputtering) nécessite une polarisation radiofréquence, cette polarisation conduisant le plus souvent à des dépôts inhomogènes en épaisseur et sur toute la largeur du substrat verrier, lorsque celle-ci est supérieure à 2m.

Dans le cas d'une couche unique déposée sur un substrat verrier, il est utile de disposer de matériaux faciles et peu couteux à déposer et dont l'indice de réfraction est inférieur à celui du substrat verrier, de manière à limiter la réflexion à la surface du substrat. Alternativement, dans le cas d'un empilement de couches à fonction antireflet, la mise à disposition dans l'empilement d'au moins une couche poreuse obtenue selon l'invention et d'indice de réfraction ajustable, c'est-à-dire en particulier dont l'indice peut être inférieure de plusieurs pourcents à celui du matériau non poreux la constituant, permet l'obtention de degrés de liberté supplémentaires pour ajuster l'effet antireflet.

La présente invention se rapporte à un vitrage comprenant un substrat sur lequel est déposé un revêtement poreux à base de silicium d'oxygène et de carbone présentant des propriétés antireflets, permettant notamment une augmentation du facteur de transmission énergétique T_{E} du rayonnement solaire incident, au sens décrit dans la norme ISO 9050 : 2003, en particulier dans la gamme de longueur d'onde 300-2500 nm pour les applications photovoltaïques.

En outre, il est nécessaire à leur utilisation qu'un tel revêtement durable soit durable dans le temps, c'est-à-dire que ses qualités optiques initiales ne soient pas ou sensiblement pas altérées par les conditions climatiques et qui puisse résister en outre efficacement aux diverses manipulations et nettoyages auxquels il est soumis.
Selon un autre aspect de la présente invention, il est ainsi proposé un vitrage muni d'un revêtement à propriétés antireflets dont les résistances mécanique, notamment à l'abrasion, et chimique, notamment hydrolytique, sont améliorées.

Plus précisément la présente invention se rapporte selon un premier aspect à un vitrage comprenant un substrat transparent, notamment verrier, muni d'un revêtement à propriété antireflet comprenant au moins une couche d'un matériau poreux comprenant essentiellement du silicium, de l'oxygène, du carbone et éventuellement de l'hydrogène, dans laquelle la proportion atomique P_{c} du carbone par rapport à la somme des contributions atomiques du silicium (P_{Si}), de l'oxygène (P_{O}) et du carbone (P_{C}) varie localement, dans le sens de l'épaisseur de la couche, depuis une première surface jusqu'à une deuxième surface de celle-ci :
- selon une augmentation entre une première valeur minimale P_{Cmin1} et une valeur maximale P_{Cmax}, le rapport entre ladite valeur maximale P_{Cmax} et ladite première valeur minimale P_{Cmin1} étant d'au moins 1,2,
- puis selon une diminution de la proportion de carbone, entre ladite valeur maximale P_{Cmax} et une seconde valeur minimale P_{Cmin2}, le rapport entre ladite valeur maximale P_{Cmax} et ladite seconde valeur minimale P_{Cmin2} étant d'au moins 1,2.

Selon des modes préférés de mise en oeuvre de la présente invention :
Ladite couche présente la composition chimique globale suivante, suivant les proportions atomiques respectives entre les seuls éléments silicium, oxygène et carbone entrant dans la composition du matériau poreux qui la constitue:
- entre 28 et 38 % de silicium,
- entre 55 et 68 % d'oxygène,
- entre 2 et 10 % de carbone.

Par « proportion atomique respective » (ou relative), on entend la proportion de chaque élément C, O ou Si par rapport à la somme totale des contributions atomiques de ces trois seuls éléments, moyennée sur l'ensemble de l'épaisseur de la couche

Le revêtement à propriété antireflet est constitué uniquement de la couche de matériau poreux, dans lequel la valeur minimale P_{Cmin1} de la proportion de carbone dans la couche poreuse est au niveau de sa surface coté air ou à proximité de celle-ci et dans lequel la valeur minimale P_{Cmin2} de la proportion de carbone dans la couche poreuse est au niveau ou à proximité de la surface du substrat.

La proportion respective en silicium dans la couche est comprise entre 30 et 35% atomique.

La proportion respective en oxygène dans la couche est comprise entre 58 et 65% atomique.

La proportion respective en carbone dans la couche est comprise entre 3 et 8% atomique.

Le taux de carbone global dans le matériau constituant la couche est inférieur à 10% atomique, de préférence inférieure à 8% atomique et de manière préférée inférieure à 5% atomique.

Les rapports P_{Cmax}/ P_{Cmin1} et/ou P_{Cmax}/ P_{Cmin2} sont supérieurs à 1,5 et de préférence sont supérieurs à 2.

La couche présente une succession de valeurs minimales P_{Cmin} et de valeurs maximales P_{Cmax} de la proportion respective de carbone, dans le sens de l'épaisseur de la couche.

L'épaisseur de la couche poreuse est comprise entre 30 et 150 nm, de préférence entre 50 et 120 nm.

L'indice de réfraction de la couche poreuse est inférieur à 1,42, de préférence est inférieur à 1,40, ou même est inférieur à 1,35.

L'invention se rapporte également à la couche poreuse telle que décrite précédemment, constituée par un matériau poreux comprenant essentiellement du silicium, de l'oxygène, du carbone et éventuellement de l'hydrogène, dans laquelle la proportion atomique P_{C} du carbone par rapport à la somme des contributions atomiques du silicium, de l'oxygène et du carbone varie localement, dans le sens de l'épaisseur de la couche, depuis une première surface jusqu'à une deuxième surface de celle-ci :
- selon une augmentation entre une première valeur minimale P_{Cmin1} et une valeur maximale P_{Cmax}, le rapport entre ladite valeur maximale P_{Cmax} et ladite première valeur minimale P_{Cmin1} étant d'au moins 1,2,
- puis selon une diminution de la proportion de carbone, entre ladite valeur maximale Pₘₐₓ et une seconde valeur minimale P_{Cmin2}, le rapport entre ladite valeur maximale Pₘₐₓ et ladite seconde valeur minimale P_{Cmin2} étant d'au moins 1,2.

En outre la présente invention se rapporte au procédé de fabrication d'un vitrage tel que décrit précédemment et comprenant les étapes suivantes :
- on génère un plasma à la surface du substrat et sur toute la largeur, au moyen d'un dispositif comprenant au moins deux sources de faisceau plasma incluant chacune une cavité dans laquelle est générée une décharge, une buse qui s'étend vers l'extérieur et une pluralité d'aimants placés les uns en face des autres et disposés de manière adjacente à la cavité de décharge, de telle manière qu'une région exempte de champ magnétique soit créée à l'intérieur de chaque cavité de décharge, un gaz ionisable comprenant de l'oxygène étant introduit dans chaque cavité de décharge et chaque source de faisceau plasma faisant alternativement office d'anode ou de cathode,
- on fait défiler le substrat sous les faisceaux plasmas,
- on dépose sur ledit substrat, entre les deux sources plasmas, au moins un composé précurseur de silicium,
- on récupère le substrat muni d'une couche d'un matériau comprenant du silicium, de l'oxygène, du carbone, et éventuellement de l'hydrogène,
- on traite thermiquement la couche ainsi déposée, dans des conditions permettant l'élimination d'au moins une partie du carbone et l'obtention de ladite couche du matériau poreux.

Avantageusement, dans le procédé de fabrication selon l'invention,
- le gaz ionisable est un mélange d'argon et d'oxygène sous une pression totale des gaz comprise entre 10⁻³ et 10⁻² mbar,
- le ou les précurseurs de silicium sont choisis parmi les organométalliques de silicium, en particulier choisi(s) parmi les siloxanes, par exemple l'hexamethyldisiloxane (HMDSO), ou le tétraméthyldisiloxane (TDMSO), les alkylsilanes, par exemple le diétoxymethylsilane (DEMS), Si(CH₃)₃)₂ (HMDS), Si(CH₃)₄ (TMS), (SiO(CH₃)₂)₄, (SiH(CH₃)₂)₂, les alcoolates de silicium, par exemple Si(OC₂H₅)₄ (TEOS), Si(OCH₃)₄ (TMOS), ou encore les hydrures de silicium, en particulier SiH₄ ou Si₂H₆, ou les chlorures de silicium, en particulier SiCl₄, CH₃SiCl₃, (CH₃)₂SiCl₂, de préférence parmi le HDMSO ou le TDMSO.

Selon d'autres réalisations possibles conformes à la présente invention :
- on ajoute des gaz additionnels de type CH₄ ou C₂H₂ dont le rôle est d'augmenter le taux de CH dans la couche avant trempe. Ces gaz peuvent être injectés en même temps que le précurseur de Si ou séparément dans le compartiment mais toujours à proximité du plasma généré par le dispositif.
- en fonction du type de revêtement recherché, on choisira soit un précurseur comprenant une faible quantité d'hydrogène, pour l'obtention d'une couche ne contenant pas ou peu d'hydrogène tel que TDMSO, soit un précurseur du type HDMSO comprenant une plus forte quantité d'hydrogène, pour l'obtention d'une couche primaire contenant de l'hydrogène, du type SiOₓC_{y}H_{z},
- le traitement thermique est effectué sous air,
- le traitement thermique est effectué sous vide,
- le traitement thermique est une trempe, un bombage,
- le traitement thermique est un procédé de traitement tel que décrit dans la demande WO2008/096089, dans lequel on porte chaque point de la couche à une température d'au moins 300°C en maintenant une température inférieure ou égale à 150°C en tout point de la face dudit substrat opposée à ladite première face,
- Le dépôt de la couche poreuse est réalisé sur une première face du substrat, dans la ou les mêmes cavités sous vide utilisés pour le dépôt magnétron d'un empilement de couches minces à fonctionnalité bas émissive ou antisolaire, sur l'autre face dudit substrat.

L'invention et ses avantages seront mieux compris à la lecture de l'exemple qui suit.

### Exemple selon l'invention:

Dans cet exemple selon l'invention, une première couche de revêtement comprenant du silicium, du carbone et de l'oxygène est déposée selon le dispositif et les principes décrits dans la demande US 7,411,352, en particulier colonnes 12 ligne 4 à colonne 14 ligne 7 et en relation avec les figures 12A et 12B.

Plus précisément, le dispositif utilisé, fourni par la société Général Plasma Inc. comprend deux sources de faisceau plasma, connectées sur une alimentation CA pour produire alternativement des faisceaux plasma et ionique permettant de déposer le matériau comprenant du silicium, de l'oxygène et du carbone sur le substrat. Chaque source de faisceau plasma comprend une cavité de décharge présentant une première largeur et une buse qui s'étend vers l'extérieur à partir de la cavité pour émettre le faisceau ionique. L'ouverture ou sortie de la buse présente une deuxième largeur inférieure à la première largeur. Comme indiqué sur les figures 12A et 12B de la publication US 7,411,352, une pluralité d'aimants généralement placés les uns en face des autres sont disposés de manière adjacente à la cavité de décharge pour créer une région exempte de champ magnétique à l'intérieur de la cavité de décharge. L'alimentation CA est connectée à des électrodes dans chaque cavité de décharge et chaque source de faisceau plasma fait alternativement office d'anode ou de cathode. Au moins une région de décharge de magnétrons faisant office de cathode est présente à l'intérieur de la cavité de décharge. En cours de fonctionnement, un faisceau plasma dense et uniforme émane de la source cathodique et un faisceau ionique émane de la source anodique. L'homme du métier pourra notamment trouver toutes les informations techniques nécessaires en ce qui concerne le fonctionnement d'une telle installation dans le brevet US 7411352, cité en référence.

Le substrat utilisé dans cet exemple est un vitrage verrier commercialisé sous la marque Diamant ® par la société déposante. Le précurseur utilisé est le HDMSO (hexamethyldisiloxane). Il est introduit sous forme gazeuse au niveau du substrat entre les deux sources plasmas, au moyen de deux déflecteurs en aluminium orientant le flux du précurseur vers chaque faisceau plasma/ionique, en sortie de buse.

Un précurseur du type HDMSO comprenant une forte quantité d'hydrogène, est utilisé dans le gaz plasma pour l'obtention d'une couche primaire contenant de l'hydrogène, du type SiOₓC_{y}H_{z}.

Le gaz plasma utilisé dans le présent exemple est un mélange d'oxygène et d'argon dans les proportions données dans le tableau 1 qui suit, regroupant les principales données expérimentales du dépôt de la couche selon l'invention. La puissance délivrée par l'alimentation CA, telle que rapportée dans le tableau 1, engendre la création de la décharge électrique dans chaque cavité et la génération du plasma et des ions qui permettent le craquage du précurseur puis la formation d'un revêtement primaire comprenant des atomes de silicium, d'oxygène, de carbone et éventuellement d'hydrogène sur le substrat qui défile sous l'installation.

**Tableau 1**

| | |
|---|---|
| Débit HDMSO | 240 sccm |
| Débit Ar | 530 sccm |
| Débit O₂ | 920 sccm |
| Puissance délivrée par l'Alimentation CA | 6 kW |

Le substrat verrier muni de son revêtement est ensuite soumis à un traitement thermique consistant en une chauffe à 640°C pendant 8 minutes, suivi d'une trempe. Durant cette phase, une nanoporosité est créée dans le revêtement par l'élimination d'au moins une partie du carbone (et éventuellement de l'hydrogène) présents dans le matériau initialement déposé. Cette porosité a pour effet de diminuer l'indice de réfraction du matériau, lui conférant ainsi un effet antireflet des rayons lumineux incidents, notamment dans la gamme 300-2500 nm pour une application photovoltaïque. Cette diminution de l'indice de réfraction peut notamment être directement mesurée par l'augmentation ΔT_{E} résultante, mesurée en pourcentage du facteur de transmission énergétique T_{E} du substrat muni de la couche à propriétés antireflet, par rapport à la valeur référence préalablement mesurée du même substrat mais non revêtu.

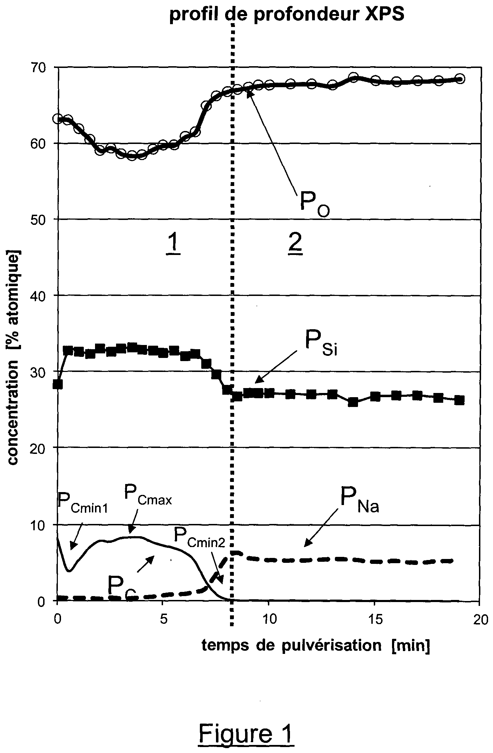

Sur la figure 1, on a reporté le spectre d'analyse de la composition de la couche de revêtement, obtenu par les techniques de spectrométrie de photoélectrons induits par rayons X (XPS). Les mesures ont été réalisées sur un appareillage de type Quantera SXM® de Ulvac-PHI en utilisant la radiation monochromatique K_{α} de l'aluminium. Les profils de concentration dans la profondeur de la couche ont été mesurés en alternant le bombardement d'ions pour araser la couche et des mesures de spectres de contrôle.

Sur le diagramme des concentrations respectives des différents éléments contenus dans la couche de revêtement (axe des ordonnées sur la figure 1), en fonction du temps de pulvérisation, c'est-à-dire selon la profondeur dans la couche (axe des abscisses), on note les proportions relatives des éléments C, Si et O dans ladite couche.

On observe sur la figure 1 que la couche selon l'invention présente un profil de concentration du carbone jamais encore observé à ce jour : dans les publications de l'art antérieur, notamment dans la demande EP 1 676 291, on décrit que les meilleures performances sont attendues lorsque la concentration de carbone, dans le sens de l'épaisseur de la couche, est soit sensiblement constante sur toute l'épaisseur de la couche, soit graduellement croissante, entre une valeur minimale sur la face coté « air » et une valeur maximale sur la face coté « substrat ».

Sur la figure 1, la partie 1 à gauche de la ligne verticale pointillée correspond à la couche de revêtement, selon toute son épaisseur. La partie 2 à droite de la ligne pointillée correspond à la composition du substrat verrier, après pulvérisation de la couche dans toute son épaisseur au point d'analyse.

On voit sur la figure 1 que la proportion relative en C (courbe P_{C}) du revêtement selon l'invention, dans le sens de son épaisseur, présente un profil de spectroscopie XPS totalement différent, né des conditions spécifiques du dépôt de ladite couche : la courbe de concentration en carbone passe ainsi, selon l'axe de l'épaisseur de la couche, par un premier minimum (P_{Cmin1}) proche d'une première surface de la couche (coté « air »), puis par un maximum (P_{Cmax}) et enfin par un autre minimum (P_{Cmin2}) proche de la surface opposée de la couche (coté « verre »). Conformément à la présente invention, la proportion relative en C varie ainsi entre un premier minimum depuis une première surface de la couche et jusqu'à un deuxième minimum à une deuxième surface de celle-ci, en passant par un maximum. Les inventeurs attribuent la valeur relativement élevée de la concentration de carbone sur la surface extérieure (coté « air ») de l'échantillon selon l'exemple 1 à la présence de contaminants essentiellement carbonés sur la surface externe de la couche de revêtement.

Les tests menés par la société déposante, tels que reportés dans la suite de la présente description, ont montré qu'une telle répartition permettait d'améliorer les performances de la couche poreuse non seulement au regard des propriétés optiques recherchées (effet antireflet) mais aussi de ses propriétés de résistance mécanique et chimique.

Les propriétés améliorées des substrats munis des revêtements ainsi obtenus ont été mesurées par les tests suivants :

### A- Propriétés optiques (effet antireflet)

Une diminution de la réflexion à la surface du substrat verrier se traduit par une augmentation du facteur de transmission énergétique T_{E}. Tel que décrit précédemment, les propriétés optiques du substrat muni du revêtement sont donc mesurées par la mesure de la variation de la transmission ΔT_{E}, en pourcentage, entre la transmission énergétique du substrat verrier (après trempe) muni de l'empilement et du même substrat nu. T_{E} et ΔT_{E} sont mesurés dans la partie 300-2500nm du spectre solaire, selon les critères définis dans la norme ISO 9050 : 2003 (E).

### B- Test de résistance chimique

La résistance à l'abrasion des revêtements déposés, après trempe, a été mesurée par un test de résistance à l'humidité selon la norme IEC 61215/10.13, représentatif de l'utilisation du vitrage en extérieur (test de simulation de climat), ou Damp Heat Test: l'échantillon subit des conditions d'humidité et température extrêmes (85% d'humidité relative à 85°C) pendant une durée totale de 2000h, pour en provoquer le vieillissement accéléré. L'augmentation de la transmission énergétique ΔT_{E} décrite précédemment est mesurée avant de commencer le test (voir A-), puis après 2000h de test.

### C- test de résistance mécanique (abrasion)

La résistance à l'abrasion des revêtements déposés, après trempe, a été mesurée par le test d'Erichsen: selon ce test bien connu dans le domaine en particulier de la métallurgie, on mesure la résistance du revêtement à la rayure par mise en contact de celui ci avec une aiguille en acier que l'on déplace à sa surface. On applique sur l'aiguille une force croissante, de 0,2 Newton à 6 Newtons. La résistance mécanique d'un revêtement est de cette façon mesurée en fonction de la force appliquée entrainant sa rayure.

Les résultats des différents tests A- à C- pour l'échantillon selon l'exemple 1 sont reportés dans le tableau 2 qui suit.

**Tableau 2**

| | A-ΔT_{E} après Trempe (%) | B-ΔT_{E} après Damp Heat Test (%) | C-Valeur max. au test d'Erichsen avant rayure (N) |
|---|---|---|---|
| Exemple 1 | 2,7 | 2,3 | 0,2 |
| Exemple comparatif* | 2,2 | 1,3 | 8 |

| | | | |
|---|---|---|---|
| *vitrage selon EP 1 676 291 | | | |

On voit que des performances tout à fait satisfaisantes sont obtenues, aussi bien en termes des propriétés optiques, qu'en ce qui concerne les propriétés de résistance mécanique et chimique, sont obtenues pour le vitrage selon l'invention.

La couche selon l'invention peut être utilisée dans tout type de vitrage, non seulement dans le domaine des dispositifs photovoltaïque, mais également dans le domaine du bâtiment. En particulier, dans de telles applications bâtiment, il est possible de proposer des vitrages par exemple du type DGU ou TGU dans lequel la couche poreuse selon l'invention est combinée avec un empilement bas émissif comprenant une couche fonctionnelle d'un métal précieux tel que l'argent ou l'or, la couche poreuse étant disposée au sein de l'empilement, notamment au dessus, pour en améliorer les performances, notamment pour augmenter la transmission énergétique ou encore le facteur solaire global dudit vitrage.

## Revendications

1. Vitrage comprenant un substrat transparent, notamment verrier, muni d'un revêtement à propriété antireflet comprenant au moins une couche d'un matériau poreux comprenant essentiellement du silicium, de l'oxygène, du carbone et éventuellement de l'hydrogène, **caractérisé en ce que** la proportion atomique P_{C} du carbone par rapport à la somme des contributions atomiques du silicium, de l'oxygène et du carbone varie localement, dans le sens de l'épaisseur de la couche, depuis une première surface jusqu'à une deuxième surface de celle-ci :
- selon une augmentation entre une première valeur minimale P_{Cmin1} et une valeur maximale P_{Cmax}, le rapport entre ladite valeur maximale P_{Cmax} et ladite première valeur minimale P_{Cmin1} étant d'au moins 1,2,
- puis selon une diminution de la proportion de carbone, entre ladite valeur maximale P_{Cmax} et une seconde valeur minimale P_{Cmin2}, le rapport entre ladite valeur maximale P_{Cmax} et ladite seconde valeur minimale P_{Cmin2} étant d'au moins 1,2.

2. Vitrage selon la revendication 1, dans lequel ladite couche présente la composition chimique globale suivante, selon les proportions atomiques respectives entre les seuls éléments silicium, oxygène et carbone entrant dans la composition du matériau poreux qui la constitue:
- entre 28 et 38 % de silicium,
- entre 55 et 68 % d'oxygène,
- entre 2 et 10 % de carbone.

3. Vitrage selon l'une des revendications 1 ou 2, dans lequel le revêtement à propriété antireflet est constitué uniquement de la couche de matériau poreux, dans lequel la valeur minimale P_{Cmin1} de la proportion de carbone dans la couche poreuse est au niveau de sa surface coté air ou à proximité de celle-ci et dans lequel la valeur minimale P_{Cmin2} de la proportion de carbone dans la couche poreuse est au niveau ou à proximité de la surface du substrat.

4. Vitrage selon l'une des revendications précédentes, dans lequel la proportion respective en silicium dans la couche est comprise entre 30% et 35% atomique.

5. Vitrage selon l'une des revendications précédentes, dans lequel la proportion respective en oxygène dans la couche est comprise entre 58 et 65% atomique.

6. Vitrage selon l'une des revendications précédentes, dans lequel la proportion respective en carbone dans la couche est comprise entre 3 et 8% atomique.

7. Vitrage selon l'une des revendications précédente, dans lequel le taux de carbone global dans le matériau constituant la couche est inférieur à 15% atomique, de préférence inférieure à 10% atomique et de manière préférée inférieure à 5% atomique.

8. Vitrage selon l'une des revendications précédentes, dans lequel les rapports P_{Cmax}/ P_{Cmin1} et/ou P_{Cmax}/ P_{Cmin2} sont supérieurs à 1,5 et de préférence sont supérieurs à 2.

9. Vitrage selon l'une des revendications précédentes, comprenant une succession de valeurs minimales P_{Cmin} et de valeurs maximales P_{Cmax} de la proportion respective de carbone, dans le sens de l'épaisseur de la couche.

10. Vitrage selon l'une des revendications précédentes dans lequel l'épaisseur de la couche poreuse est comprise entre 30 et 150 nm, de préférence entre 50 et 120 nm.

11. Vitrage selon l'une des revendications précédentes dans lequel l'indice de réfraction de la couche poreuse est inférieur à 1,42, de préférence est inférieur à 1,40, ou même est inférieur à 1,35.

12. Procédé de fabrication d'un vitrage selon l'une des revendications 1 à 11 comprenant les étapes suivantes :
- on génère un plasma à la surface du substrat et sur toute la largeur, au moyen d'un dispositif comprenant au moins deux sources de faisceau plasma incluant chacune une cavité dans laquelle est générée une décharge, une buse qui s'étend vers l'extérieur et une pluralité d'aimants placés les uns en face des autres et disposés de manière adjacente à la cavité de décharge, de telle manière qu'une région exempte de champ magnétique soit créée à l'intérieur de chaque cavité de décharge, un gaz ionisable comprenant de l'oxygène étant introduit dans chaque cavité de décharge et chaque source de faisceau plasma faisant alternativement office d'anode ou de cathode,
- on fait défiler le substrat sous les faisceaux plasmas,
- on dépose sur ledit substrat, entre les deux sources plasmas, au moins un composé précurseur de silicium,
- on récupère le substrat muni d'une couche d'un matériau comprenant du silicium, de l'oxygène, du carbone, et éventuellement de l'hydrogène,
- on traite thermiquement la couche ainsi déposée, dans des conditions permettant l'élimination d'au moins une partie du carbone et l'obtention de ladite couche du matériau poreux.

13. Procédé de fabrication d'un substrat transparent selon la revendication précédente, dans lequel le gaz ionisable est un mélange d'argon et d'oxygène sous une pression totale des gaz comprise entre 10⁻³ et 10⁻² mbar.

14. Procédé de fabrication d'un substrat transparent selon l'une des revendications 12 ou 13, dans lequel le ou les précurseurs de silicium sont choisis parmi les organométalliques de silicium, en particulier choisi(s) parmi les siloxanes, par exemple l'hexamethyldisiloxane (HMDSO), ou le tétraméthyldisiloxane (TDMSO), les alkylsilanes, par exemple le diétoxymethylsilane (DEMS), Si(CH₃)₃)₂ (HMDS), Si(CH₃)₄ (TMS), (SiO(CH₃)₂)₄, (SiH(CH₃)₂)₂, les alcoolates de silicium, par exemple Si(OC₂H₅)₄ (TEOS), Si(OCH₃)₄ (TMOS), ou encore les hydrures de silicium, en particulier SiH₄ ou Si₂H₆, ou les chlorures de silicium, en particulier SiCl₄, CH₃SiCl₃, (CH₃)₂SiCl₂, de préférence parmi le HDMSO ou le TDMSO.

## Patentansprüche

1. Verglasung, umfassend ein transparentes Substrat, insbesondere aus Glas, ausgestattet mit einer Beschichtung mit Antireflexeigenschaft, umfassend mindestens eine Schicht eines porösen Materials, umfassend im Wesentlichen Silicium, Sauerstoff, Kohlenstoff und eventuell Wasserstoff, **dadurch gekennzeichnet, dass** der Atomanteil P_{C} des Kohlenstoffs im Verhältnis zur Summe der Atombeiträge des Siliciums, des Sauerstoffs und des Kohlenstoffs lokal in Richtung der Dicke der Schicht von einer ersten Oberfläche bis zu einer zweiten Oberfläche derselben schwankt:
- gemäß einer Erhöhung zwischen einem ersten minimalen Wert P_{Cmin1} und einem maximalen Wert P_{Cmax}, wobei das Verhältnis zwischen dem maximalen Wert P_{Cmax} und dem ersten minimalen Wert P_{Cmin1} mindestens 1,2 beträgt,
- dann gemäß einer Verringerung des Kohlenstoffanteils zwischen dem maximalen Wert P_{Cmax} und einem zweiten minimalen Wert P_{Cmin2}, wobei das Verhältnis zwischen dem maximalen Wert P_{Cmax} und dem zweiten minimalen Wert P_{Cmin2} mindestens 1,2 beträgt.

2. Verglasung nach Anspruch 1, wobei die Schicht die folgende chemische Gesamtzusammensetzung gemäß den jeweiligen Atomanteilen allein der Elemente Silicium, Sauerstoff und Kohlenstoff aufweist, die in die Zusammensetzung des porösen Materials, das sie bildet, eingehen:
- zwischen 28 und 38 % Silicium,
- zwischen 55 und 68 % Sauerstoff,
- zwischen 2 und 10 % Kohlenstoff.

3. Verglasung nach einem der Ansprüche 1 oder 2, wobei die Beschichtung mit Antireflexeigenschaft nur von der Schicht porösen Materials gebildet ist, wobei der minimale Wert P_{Cmin1} des Kohlenstoffanteils in der porösen Schicht im Bereich ihrer luftseitigen Oberfläche oder in der Nähe derselben ist und wobei der minimale Wert P_{Cmin2} des Kohlenstoffanteils in der porösen Schicht im Bereich oder in der Nähe der Oberfläche des Substrats ist.

4. Verglasung nach einem der vorangehenden Ansprüche, wobei der jeweilige Siliciumanteil in der Schicht zwischen 30 und 35 Atomprozent beträgt.

5. Verglasung nach einem der vorangehenden Ansprüche, wobei der jeweilige Sauerstoffanteil in der Schicht zwischen 58 und 65 Atomprozent beträgt.

6. Verglasung nach einem der vorangehenden Ansprüche, wobei der jeweilige Kohlenstoffanteil in der Schicht zwischen 3 und 8 Atomprozent beträgt.

7. Verglasung nach einem der vorangehenden Ansprüche, wobei der allgemeine Kohlenstoffgehalt in dem Material, das die Schicht bildet, weniger als 15 Atomprozent, vorzugsweise weniger als 10 Atomprozent und in bevorzugter Weise weniger als 5 Atomprozent beträgt.

8. Verglasung nach einem der vorangehenden Ansprüche, wobei die Verhältnisse P_{Cmax}/P_{Cmin1} und/oder P_{Cmax}/P_{Cmin2} größer als 1,5 sind und vorzugsweise größer als 2 sind.

9. Verglasung nach einem der vorangehenden Ansprüche, umfassend eine Abfolge minimaler Werte P_{Cmin} und maximaler Werte P_{Cmax} des jeweiligen Kohlenstoffanteils in Richtung der Dicke der Schicht.

10. Verglasung nach einem der vorangehenden Ansprüche, wobei die Dicke der porösen Schicht zwischen 30 und 150 nm, vorzugsweise zwischen 50 und 120 nm, beträgt.

11. Verglasung nach einem der vorangehenden Ansprüche, wobei der Brechungsindex der porösen Schicht kleiner als 1,42, vorzugsweise kleiner als 1,40 oder sogar kleiner als 1,35 ist.

12. Verfahren zur Herstellung einer Verglasung nach einem der Ansprüche 1 bis 11, umfassend die folgenden Schritte:
- Erzeugen eines Plasmas auf der Oberfläche des Substrats und über die gesamte Breite mit Hilfe einer Vorrichtung, die mindestens zwei Plasmastrahlquellen umfasst, wobei jede einen Hohlraum, in welchem eine Entladung erzeugt wird, eine Düse, die sich nach außen erstreckt und eine Vielzahl von Magneten, die einander gegenüberliegend platziert und benachbart zu dem Entladungshohlraum angeordnet sind, enthält, sodass eine Region ohne Magnetfeld im Inneren jedes Entladungshohlraums erzeugt wird, wobei ein ionisierbares Gas, das Sauerstoff enthält, in jeden Entladungshohlraum eingeleitet wird und jede Plasmastrahlquelle abwechselnd als Anode oder als Kathode dient,
- Führen des Substrats unter den Plasmastrahlen hindurch,
- Aufbringen auf das Substrat, zwischen den zwei Plasmaquellen, mindestens einer Silicium-Vorläuferverbindung,
- Rückgewinnen des Substrats, ausgestattet mit einer Schicht eines Materials, das Silicium, Sauerstoff, Kohlenstoff und eventuell Wasserstoff umfasst,
- thermisches Behandeln der derart aufgebrachten Schicht unter Bedingungen, welche das Entfernen von mindestens einem Teil des Kohlenstoffs und das Erhalten der Schicht des porösen Materials erlauben.

13. Herstellungsverfahren eines transparenten Substrats nach dem vorangehenden Anspruch, wobei das ionisierbare Gas ein Gemisch aus Argon und Sauerstoff unter einem Gesamtdruck der Gase zwischen 10⁻³ und 10⁻² mbar ist.

14. Herstellungsverfahren eines transparenten Substrats nach einem der Ansprüche 12 oder 13, wobei der oder die Siliciumvorläufer aus den organometallischen Verbindungen des Siliciums ausgewählt sind, insbesondere ausgewählt aus den Siloxanen, beispielsweise Hexamethyldisiloxan (HMDSO) oder Tetramethyldisiloxan (TDMSO), den Alkylsilanen, beispielsweise Diethoxymethylsilan (DEMS), Si(CH₃)₃)₂ (HMDS), Si(CH₃)₄ (TMS), (SiO(CH₃)₂)₄, (SiH(CH₃)₂)₂, den Silicium-Alkoholaten, beispielsweise Si(OC₂H₅)₄ (TEOS), Si(OCH₃)₄ (TMOS), oder auch den Siliciumhydriden, insbesondere SiH₄ oder Si₂H₆, oder den Siliciumchloriden, insbesondere SiCl₄, CH₃SiCl₃, (CH₃)₂SiCl₂, vorzugsweise aus HDMSO oder TDMSO.

## Claims

1. A glazing unit comprising a transparent, especially glass, substrate equipped with an antireflection coating, which coating comprises at least one film of a porous material essentially comprising silicon, oxygen, carbon and possibly hydrogen, **characterized in that** the atomic proportion P_{C} of carbon, relative to the sum of the atomic contributions of silicon, oxygen and carbon, varies locally in the thickness direction of the film, from a first surface to a second surface thereof:
- increasing between a first minimum value P_{Cmin1} and a maximum value P_{Cmax}, the ratio of said maximum value P_{Cmax} to said first minimum value P_{Cmin1} being at least 1.2; and
- the proportion of carbon then decreasing, between said maximum value P_{Cmax} and a second minimum value P_{Cmin2}, the ratio of said maximum value P_{Cmax} to said second minimum value P_{Cmin2} being at least 1.2.

2. The glazing unit as claimed in claim 1, in which said film has the following general chemical composition, in terms of the respective atomic proportions of just the constituent silicon, oxygen and carbon elements of the composition of the porous material from which said film is made:
- between 28 and 38% silicon;
- between 55 and 68% oxygen; and
- between 2 and 10% carbon.

3. The glazing unit as claimed in either one of claims 1 and 2, in which the antireflection coating consists only of the film of porous material, in which the minimum value P_{Cmin1} of the proportion of carbon in the porous film is reached at the air-side surface of said film or near said surface, and in which the minimum value P_{Cmin2} of the proportion of carbon in the porous film is reached at or near the surface of the substrate.

4. The glazing unit as claimed in one of the preceding claims, in which the respective proportion of silicon in the film is between 30 at% and 35 at%.

5. The glazing unit as claimed in one of the preceding claims, in which the respective proportion of oxygen in the film is between 58 at% and 65 at%.

6. The glazing unit as claimed in one of the preceding claims, in which the respective proportion of carbon in the film is between 3 at% and 8 at%.

7. The glazing unit as claimed in one of the preceding claims, in which the overall amount of carbon in the material of the film is lower than 15 at%, preferably lower than 10 at% and even more preferably lower than 5 at%.

8. The glazing unit as claimed in one of the preceding claims, in which the ratios P_{Cmax}/P_{Cmin1} and/or P_{Cmax}/P_{Cmin2} are higher than 1.5 and preferably higher than 2.

9. The glazing unit as claimed in one of the preceding claims, comprising a succession of minimum values P_{Cmin} and maximum values P_{Cmax} of the respective proportion of carbon, in the thickness direction of the film.

10. The glazing unit as claimed in one of the preceding claims, in which the porous film is between 30 and 150 nm in thickness and preferably between 50 and 120 nm in thickness.

11. The glazing unit as claimed in one of the preceding claims, in which the refractive index of the porous film is lower than 1.42 and preferably is lower than 1.40 or even lower than 1.35.

12. A process for manufacturing a glazing unit as claimed in one of claims 1 to 11, comprising the following steps:
- a plasma is generated at the surface of the substrate over its entire width by means of a device comprising at least two plasma beam sources each comprising a cavity in which a discharge is generated, a nozzle that extends toward the exterior, and a plurality of magnets placed facing one another and arranged adjacent the discharge cavity, such that a magnetic-field free region is created inside each discharge cavity, an oxygen-containing ionizable gas being introduced into each discharge cavity and each plasma beam source alternately serving as an anode or a cathode;
- the substrate is run under the plasma beams;
- at least one silicon precursor compound is deposited on said substrate between the two plasma sources;
- the substrate equipped with a film of a material comprising silicon, oxygen, carbon, and possibly hydrogen, is recovered; and
- the film thus deposited is subjected to a heat treatment under conditions allowing at least part of the carbon to be removed and said film of the porous material to be obtained.

13. The process for manufacturing a transparent substrate as claimed in the preceding claim, in which the ionizable gas is a mixture of argon and oxygen the total pressure of the gasses being between 1×10⁻³ and 1×10⁻² mbar.

14. The process for manufacturing a transparent substrate as claimed in either one of claims 12 or 13, in which the one or more silicon precursors are chosen from silicon organometallics, and in particular chosen from siloxanes, for example hexamethyl disiloxane (HMDSO), or tetramethyl disiloxane (TDMSO), alkylsilanes, for example diethoxymethylsilane (DEMS), Si(CH₃)₃)₂ (HMDS), Si(CH₃)₄ (TMS), (SiO(CH₃)₂)₄, (SiH(CH₃)₂)₂, silicon alcoholates, for example Si(OC₂H₅)₄ (TEOS), Si(OCH₃)₄ (TMOS), or even silicon hydrides, in particular SiH₄ or Si₂H₆, or silicon chlorides, in particular SiCl₄, CH₃SiCl₃, (CH₃)₂SiCl₂, preferably from HDMSO or TDMSO.
